# EUROPÄISCHE PATENTSCHRIFT

(11) **EP 2 449 606 B1**
(45) Veröffentlichungstag und Bekanntmachung des Hinweises auf die Patenterteilung: **27.07.2016**
(21) Anmeldenummer: 10720929.8
(22) Anmeldetag: 28.05.2010
(51) Int. Cl.: H01L 33/48, H01L 33/54

(54) **OPTOELEKTRONISCHES BAUTEIL**
OPTOELECTRONIC COMPONENT
COMPOSANT OPTOÉLECTRONIQUE

(30) Priorität: 29.06.2009 DE 102009031008
(43) Veröffentlichungstag der Anmeldung: 09.05.2012
(73) Patentinhaber: OSRAM Opto Semiconductors GmbH, 93055 Regensburg (DE); Heraeus Deutschland GmbH & Co. KG, 63450 Hanau (DE)
(72) Erfinder: ZITZLSPERGER, Michael, 93047 Regensburg (DE); DITZEL, Eckhard, 63589 Linsengericht (DE); SORG, Jörg, Erich, 93053 Regensburg (DE)
(74) Vertreter: Epping - Hermann - Fischer
(86) Internationale Anmeldenummer: PCT/EP2010/057442
(87) Internationale Veröffentlichungsnummer: WO 2011/000642

(56) Entgegenhaltungen:
- EP-A1- 1 978 566
- WO-A1-2007/018560
- US-A1- 2008 029 775
- US-A1- 2008 054 286
- US-A1- 2008 122 123
- US-B1- 6 765 801

## Beschreibung

Es wird ein optoelektronisches Bauteil angegeben.

US20080122123 offenbart ein optoelektronisches Bauteil mit einem Anschlussträger, umfassend eine elektrisch isolierende Schicht an einer Oberseite des Anschlussträgers, einem Leuchtdioden-Chip an der Oberseite des Anschlussträgers, einer Ausnehmung in die elektrisch isolierende Schicht, die den Leuchtdioden-Chip rahmenartig umschliesst, und einem Vergusskörper, der den Leuchtdioden-Chip umgibt, wobei der Vergusskörper zumindest stellenweise bis zu einer dem Leuchtdioden-Chip zugewandten Außenkante der Ausnehmung reicht, und die Ausnehmung zumindest stellenweise frei vom Vergusskörper ist.

Eine zu lösende Aufgabe besteht darin, ein optoelektronisches Bauteil anzugeben, das besonders einfach und kostengünstig herstellbar ist.

Gemäß der Erfindung wird ein optoelektronisches Bauteil gemäß Anspruch 1 angegeben.

Das optoelektronische Bauteil umfasst einen Anschlussträger. Bei dem Anschlussträger handelt es sich beispielsweise um eine Leiterplatte, auf der oder in der Anschlussstellen sowie Leiterbahnen zum Anschließen und Kontaktieren von elektronischen Komponenten vorgesehen sind. Der Anschlussträger umfasst eine elektrisch isolierende Folie an einer Oberseite des Anschlussträgers. Bei der elektrisch isolierenden Folie handelt es sich um eine Schicht aus einem elektrisch isolierenden Material. Beispielsweise handelt es sich bei der elektrisch isolierenden Folie um eine Kunststofffolie.

Das optoelektronische Bauteil umfasst einen optoelektronischen Halbleiterchip, der an der Oberseite des Anschlussträgers auf dem Anschlussträger angeordnet ist. Bei dem optoelektronischen Halbleiterchip handelt es sich beispielsweise um einen strahlungsemittierenden Halbleiterchip, wie einen Leuchtdiodenchip oder einen Laserdiodenchip. Ferner kann es sich bei dem optoelektronischen Halbleiterchip auch um einen

strahlungsempfangenden Halbleiterchip wie beispielsweise einen Fotodiodenchip handeln.

Das optoelektronische Bauteil umfasst eine Ausnehmung in der elektrisch isolierenden Folie, die den optoelektronischen Halbleiterchip rahmenartig umschließt. Das heißt, in die elektrisch isolierende Folie an der Oberseite des Anschlussträgers ist eine Ausnehmung eingebracht. Diese Ausnehmung kann beispielsweise durch Materialabtrag, das heißt durch Entfernen eines Teils der elektrisch isolierenden Folie, erzeugt sein. Die Ausnehmung ist dabei derart ausgebildet, dass sie den optoelektronischen Halbleiterchip rahmenartig umschließt. Der Begriff "rahmenartig" ist dabei hinsichtlich der Form und des Verlaufes der Ausnehmung nicht als einschränkend zu verstehen. Beispielsweise kann die Ausnehmung eine runde, eine ovale oder auch eine rechteckige Form aufweisen. Die Ausnehmung kann beispielsweise nach Art eines Grabens in der elektrisch isolierenden Folie ausgebildet sein, der den optoelektronischen Halbleiterchip vollständig umschließt. Zwischen dem optoelektronischen Halbleiterchip und der Ausnehmung kann sich dann ein Bereich der elektrisch isolierenden Folie befinden, der nicht strukturiert ist. Das heißt, in diesem Bereich ist die elektrisch isolierende Folie dann intakt.

Das optoelektronische Bauteil umfasst einen Vergusskörper, der den optoelektronischen Halbleiterchip umgibt. Der optoelektronische Halbleiterchip ist an seinen freiliegenden Flächen, das heißt an den Flächen, die nicht an den Anschlussträger grenzen, vom Vergusskörper bedeckt. Beispielsweise befindet sich der Vergusskörper dort in direktem Kontakt mit dem Halbleiterchip. Der Vergusskörper ist vorzugsweise für eine vom optoelektronischen Halbleiterchip auszusendende oder für eine vom optoelektronischen Halbleiterchip zu empfangende elektromagnetische Strahlung durchlässig ausgebildet. Beispielsweise enthält oder besteht der Vergusskörper aus einem Silikon.

Die Bodenfläche der Ausnehmung in der elektrisch isolierenden Folie ist durch die elektrisch isolierende Folie gebildet. Das heißt, die Ausnehmung durchdringt die elektrisch isolierende Folie nicht vollständig, sondern im Bereich der Ausnehmung ist die elektrisch isolierende Folie lediglich bis zu einer bestimmten Tiefe entfernt, die Bodenfläche der Ausnehmung ist dann durch nicht entfernte Bereiche der elektrisch isolierenden Folie gebildet. Dabei durchdringt die Ausnehmung die elektrisch isolierende Folie an keiner Stelle. Das heißt, die elektrisch isolierende Kunststoffschicht ist nur teilweise abgetragen, sie ist durch die Ausnehmung nicht durchbrochen. Auf diese Weise ist es beispielsweise verhindert, dass Material - beispielsweise Material des Vergusskörpers 10 - von der Oberseite des Anschlussträgers zu einer der Oberseite abgewandten Unterseite des Anschlussträgers durch die Ausnehmung hindurch gelangt. Dies hat den Vorteil, dass zum Beispiel eine Kontaminierung der Unterseite des Anschlussträgers, an der sich beispielsweise elektrische Anschlussstellen zur Kontaktierung des optoelektronischen Bauteils befinden können, verhindert ist.

Der Vergusskörper reicht zumindest stellenweise bis zu einer dem optoelektronischen Halbleiterchip zugewandten Außenkante der Ausnehmung. Mit anderen Worten befindet sich der Vergusskörper zumindest stellenweise mit einer Außenkante der Ausnehmung, die dem optoelektronischen Halbleiterchip zugewandt ist, in Kontakt. Die Außenkante der Ausnehmung wirkt dabei als Stoppkante für das Material des Vergusskörpers. Damit die Außenkante der Ausnehmung die Funktion als Stoppkante erfüllt, ist die Außenkante vorzugsweise nicht abgerundet, sondern weist eine Ecke auf, die beispielsweise in einem 90° -Winkel oder einem Winkel kleiner 90° verläuft. Das heißt, die Außenkante ist scharf definiert, weist keine Rundungen, keine Scharten oder Kerben auf.

Die Ausnehmung ist zumindest stellenweise frei vom Vergusskörper. Das heißt, der Vergusskörper tritt zumindest an manchen Stellen der Ausnehmung nicht in die Ausnehmung ein. Vorzugsweise ist die Ausnehmung frei oder im Wesentlichen frei vom Vergusskörper. "Im Wesentlichen frei" heißt dabei, dass herstellungsbedingt kleine Mengen von Material des Vergusskörpers in der Ausnehmung vorhanden sein können, das Material des Vergusskörpers jedoch höchstens 5 % des Volumens, vorzugsweise höchstens 2,5 %, besonders bevorzugt höchstens 1 % des Volumens der Ausnehmung ausfüllt. Insbesondere ist eine Bodenfläche der Ausnehmung vorzugsweise frei vom Vergusskörper. Das heißt, Material des Vergusskörpers kann unter Umständen an den die Ausnehmung begrenzenden Seitenflächen der Ausnehmung vorhanden sein, die Ausnehmung ist jedoch nicht mit dem Material des Vergusskörpers gefüllt und damit zumindest stellenweise, vorzugsweise vollständig frei vom Vergusskörper.

Gemäß zumindest einer Ausführungsform des optoelektronischen Bauteils reicht der Vergusskörper entlang der gesamten Ausnehmung an die dem optoelektronischen Halbleiterchip zugewandte Außenkante der Ausnehmung. Das heißt, die Ausnehmung, die den Halbleiterchip rahmenförmig umschließt, wirkt als Stoppkante für den Vergusskörper. Auf diese Weise ist die Form des Vergusskörpers in der Haupterstreckungsebene der elektrisch isolierenden Folie durch den Verlauf der Ausnehmung vorgegeben. Vorteilhafterweise kann auf diese Weise eine hohe Positioniergenauigkeit des Vergusskörpers erreicht werden, da sich dieser selbstständig an der Außenkante der Ausnehmung positioniert. Je nach Form der Ausnehmung können frei geformte Konturen des Vergusskörpers erzeugt werden, wie beispielsweise runde, ovale, rechteckige oder andere Formen. Aufgrund der Tatsache, dass sich der Vergusskörper mittels der Ausnehmung selbst positioniert, ist eine besonders schnelle und kostengünstige Herstellung sowie eine schnelle und preisgünstige Änderung des Designs des optoelektronischen Bauteils möglich. Das Design des optoelektronischen Bauteils kann beispielsweise durch eine einfache Veränderung der Formgebung der Ausnehmung individuellen Einsatzerfordernissen angepasst werden. Schließlich ist es möglich, optoelektronische Bauteile mit besonders kleinen Abständen zwischen den Vergusskörpern im Verbund zu erzeugen und den Verbund erst nach Aufbringen der Vergusskörper zu einzelnen optoelektronischen Bauteilen zu vereinzeln. Aufgrund der Positionierung des Vergusskörpers durch die Ausnehmung ist es möglich, benachbarte optoelektronische Bauteile im Verbund näher aneinander anzuordnen, als dies beispielsweise der Fall ist, wenn der Vergusskörper mittels einer Form auf dem Anschlussträger erzeugt wird.

Gemäß zumindest einer Ausführungsform des optoelektronischen Bauteils umfasst der Anschlussträger eine elektrisch leitende Folie, die an der der Oberseite des Anschlussträgers abgewandten Seite der elektrisch isolierenden Folie an der elektrisch isolierenden Folie befestigt ist. Das heißt, bei dem Anschlussträger handelt es sich um einen zweischichtigen Träger, der beispielsweise flexibel ausgebildet sein kann. Bei der elektrisch leitenden Folie kann es sich um eine Folie aus einem Metall, zum Beispiel eine Aluminiumfolie oder eine Kupferfolie, handeln, die an der elektrisch isolierenden Folie befestigt ist. Die elektrisch leitende Folie befindet sich an der Unterseite des Anschlussträgers und bildet beispielsweise die Anschlussstellen des optoelektronischen Bauteils. Die elektrisch leitende Folie ist dazu in zwei oder zumindest zwei elektrisch voneinander isolierte Bereiche strukturiert. Diese Bereiche können durch die elektrisch isolierende Folie zusammengehalten werden. Das heißt, die elektrisch isolierende Folie gibt dem optoelektronischen Bauteil die notwendige mechanische Stabilität.

Gemäß zumindest einer Ausführungsform des optoelektronischen Bauteils besteht der Anschlussträger aus der elektrisch leitenden Folie, der elektrisch isolierenden Folie und gegebenenfalls einem Verbindungsmittel das zwischen der elektrisch leitenden Folie und der elektrisch isolierenden Folie angeordnet sein kann. Bei dem Verbindungsmittel handelt es sich beispielsweise um einen Klebstoff. Elektrisch isolierende Folie und elektrisch leitende Folie sind in diesem Fall mittels des Verbindungsmittels miteinander verklebt. Es ist jedoch auch möglich, dass die elektrisch isolierende Folie und elektrisch leitende Folie die einzigen Schichten des Anschlussträgers sind und der Anschlussträger verbindungsmittelfrei ist. In diesem Fall ist der Anschlussträger als Laminat ausgebildet.

Der Vergusskörper kann durch Dispensen oder Vergießen hergestellt werden, wobei die Außenkante der Ausnehmung, die dem optoelektronischen Halbleiterchip zugewandt ist, eine Stoppkante für den Vergusskörper bildet. Mit anderen Worten wird das Material des Vergusskörpers im flüssigen oder zähflüssigen Zustand auf den optoelektronischen Halbleiterchip und den Anschlussträger in dem Bereich aufgebracht, der rahmenartig durch die Ausnehmung in der elektrisch isolierenden Folie begrenzt ist. Die dem optoelektronischen Halbleiterchip zugewandte Außenkante der Ausnehmung bildet die Stoppkante für das Material des Vergusskörpers, so dass sich seine Form in der Ebene der elektrisch isolierenden Folie entsprechend des Verlaufes der Ausnehmung ausbildet. Die Geometrie des Vergusskörpers ergibt sich dann aus der Menge, also zum Beispiel aus dem Volumen des aufgetragenen Materials, sowie der Oberflächenspannung des Materials des Vergusskörpers, der Oberflächenenergie der Folie sowie des aufgetragenen Materials, bzw. dem Benetzungswinkel. Die Umfangslinie des Vergusskörpers in der Ebene der elektrisch isolierenden Folie wird durch die dem Halbleiterchip zugewandte Außenkante der Ausnehmung definiert. Der Vergusskörper ist dann - je nach Oberflächenspannung des verwendeten Materials - konvex, das heißt kuppelartig ausgebildet und seine Außenfläche weist die Form einer sphärischen oder asphärischen Linse auf.

Die Ausnehmung kann mittels eines Laserstrahls erzeugt werden. Das heißt, bei einem Verfahren zur Herstellung des optoelektronischen Bauteils wird zunächst die hier beschriebene Ausnehmung mittels eines Laserstrahls in die elektrisch isolierende Folie eingebracht, anschließend kann der Vergusskörper durch Dispensen hergestellt werden, wobei die Außenkante der mittels Laserstrahlung erzeugten Ausnehmung eine Stoppkante für den Vergusskörper bildet. Anschließend wird das Material des Vergusskörpers ausgehärtet, so dass ein mechanisch stabiler Vergusskörper um den optoelektronischen Halbleiterchip herum entsteht.

Gemäß zumindest einer Ausführungsform des optoelektronischen Bauteils weist die Ausnehmung einen rechteckigen Querschnitt auf. Das heißt die Bodenfläche sowie die Seitenflächen der Ausnehmung bilden im Querschnitt ein Rechteck, das jedoch an seiner der Bodenflächen abgewandten Seite nicht geschlossen ist. Die Ausnehmung ist also beispielsweise als im Querschnitt rechteckiger Graben in die elektrisch isolierende Folie eingebracht. Es hat sich dabei gezeigt, dass solche Ausnehmungen mit besonders scharfen Außenkanten besonders genau und effizient durch Abtragen des Materials der elektrisch isolierenden Folie mittels eines Laserstrahls erzeugt werden können.

Im Folgenden wird das hier beschriebene optoelektronische Bauteil anhand von Ausführungsbeispielen und den dazugehörigen Figuren näher erläutert.
Die Figuren 1A bis 1C zeigen schematische Ansichten eines optoelektronischen Bauteils gemäß einem Ausführungsbeispiel.
Die Figuren 2A bis 2F zeigen mikroskopische Aufnahmen eines Vergusskörpers, wie er in einem optoelektronischen Bauteil zum Einsatz kommen kann.
Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

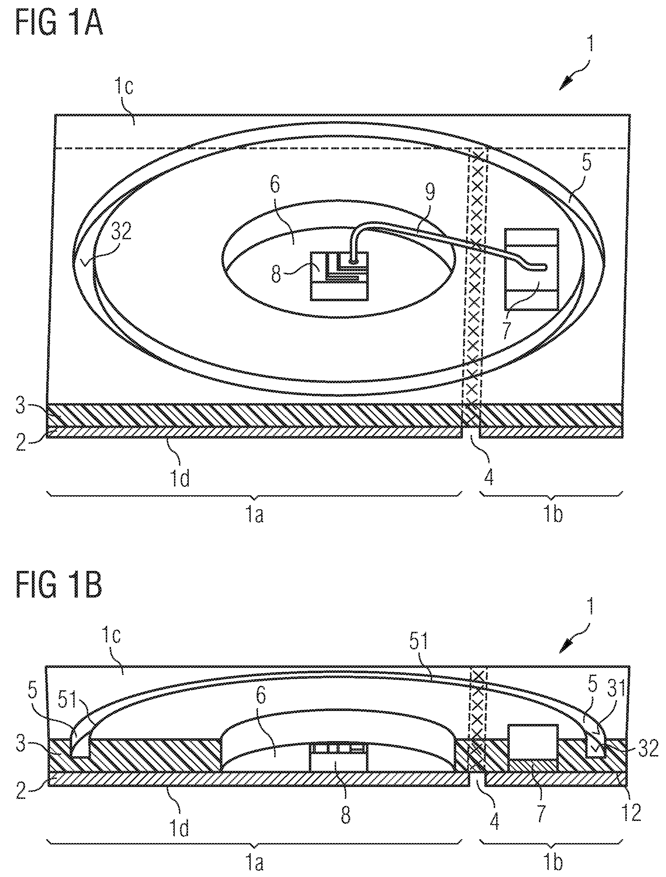

Die Figur 1A zeigt ein Ausführungsbeispiel eines optoelektronischen Bauteils in einer schematischen Perspektivdarstellung ohne Vergusskörper. Das optoelektronische Bauteil umfasst einen Anschlussträger 1. Der Anschlussträger 1 besteht beispielsweise genau aus zwei Schichten. Der Anschlussträger 1 besteht dann aus einer elektrisch leitenden Schicht 2, die zum Beispiel als Kupferfolie ausgebildet ist. Ferner umfasst der Anschlussträger 1 eine elektrisch isolierende Folie 3, die beispielsweise als Kunststofffolie ausgebildet ist. Zwischen elektrisch isolierender Folie 3 und elektrisch leitender Folie 2 kann sich ein Verbindungsmittel 12 befinden, das eine mechanische Verbindung zwischen den beiden Folien 2, 3 vermittelt. Die elektrisch isolierende Folie enthält oder besteht dabei zum Beispiel aus einem der folgenden Materialien: Polyimid, glasfaserverstärktes Epoxid, Silikon, Polymethacrylimid. Die Folie 3 kann auch als Folienverbund aus glasfaserverstärktem Epoxid mit einer Deckschicht aus Polytetrafluorethylen oder Polyetherimid ausgebildet sein. Ferner ist es möglich, dass Material, wie zum Beispiel eines der genannten Materialien, durch Drucken auf das glasfaserverstärkte Epoxid aufgebracht ist.

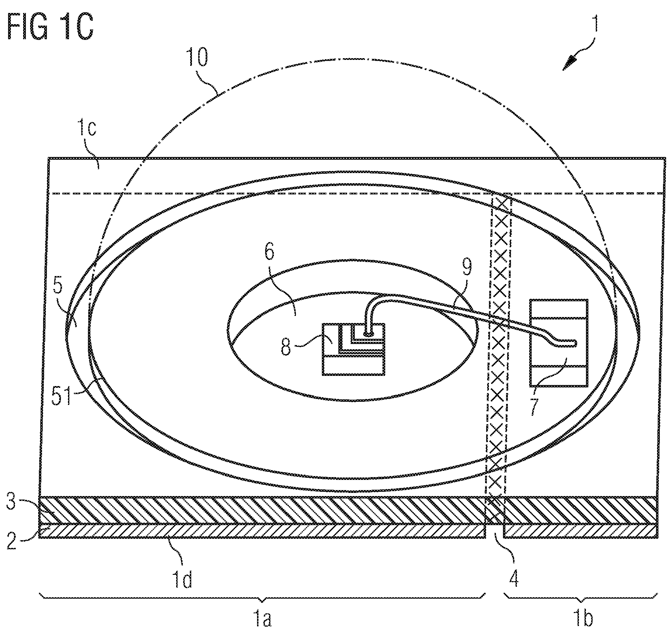

Die elektrisch leitende Folie 2 weist zwei Bereiche auf, die elektrisch voneinander isoliert sind (siehe auch die angedeutete Trennlinie in den Figuren 1A, 1B, 1C). Die Bereiche der elektrisch leitenden Folie 2 werden durch die elektrisch isolierende Folie 3 mechanisch zusammengehalten. Der Anschlussträger 1 ist auf diese Weise lateral in einen ersten Teilbereich 1a und einen zweiten Teilbereich 1b unterteilt, in denen sich an der Unterseite 1d des Anschlussträgers die durch die elektrisch leitende Folie 2 gebildeten Anschlussstellen des optoelektronischen Bauteils befinden.

An der Oberseite 1c weist der Anschlussträger 1 einen ersten Anschlussbereich 6 auf, in dem die elektrisch isolierende Folie 3 vollständig entfernt ist. In diesem ersten Anschlussbereich 6 ist der optoelektronische Halbleiterchip 8 angeordnet. Ferner weist der Anschlussträger 1 an seiner Oberseite 1c einen zweiten Anschlussbereich 7 auf, in dessen Bereich ebenfalls die elektrisch isolierende Folie 3 vollständig entfernt ist. Der zweite Anschlussbereich 7 dient beispielsweise zum elektrischen Anschließen des Halbleiterchips 8 mittels eines Bonddrahtes 9. Um den optoelektronischen Halbleiterchip 8 sowie den ersten Anschlussbereich 6 und den zweiten Anschlussbereich 7 herum ist in die elektrisch isolierende Folie 3 die Ausnehmung 5 eingebracht, die im Querschnitt rechteckig ausgebildet ist und deren Bodenfläche 32 sowie deren Seitenflächen 31 durch die elektrisch isolierende Folie 3 gebildet sind. Das heißt, die Ausnehmung durchdringt die elektrisch isolierende Folie, anders als im ersten und im zweiten Anschlussbereich 6, 7 nicht vollständig, sondern an der Bodenfläche 32 der Ausnehmung verbleibt ein Rest elektrisch isolierender Folie 3. Dies hat den Vorteil, dass beispielsweise Material des Vergusskörpers 10, siehe dazu Figur 1C, nicht durch die Ausnehmung 5 hindurch zur Unterseite 1d des Anschlussträgers 1 gelangen kann, wo es beispielsweise die Anschlussstellen, das heißt die elektrisch leitende Folie 2, beschmutzen könnte.

Der Vergusskörper 10 wird mittels Dispensen, das heißt im flüssigen oder zäh-flüssigen Zustand, in den durch die Ausnehmung 5 strukturierten Bereich des Anschlussträgers 1 an dessen Oberfläche 1c aufgebracht und anschließend ausgehärtet.

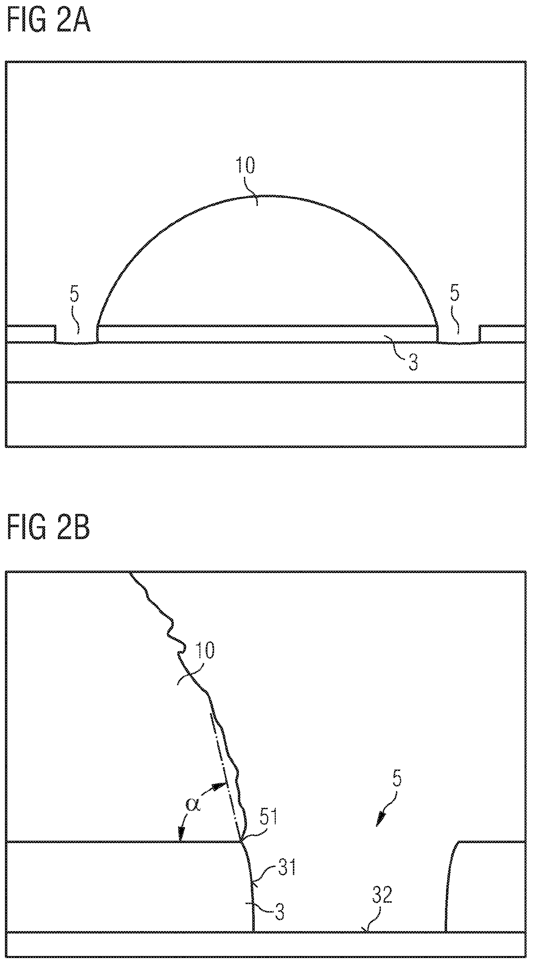

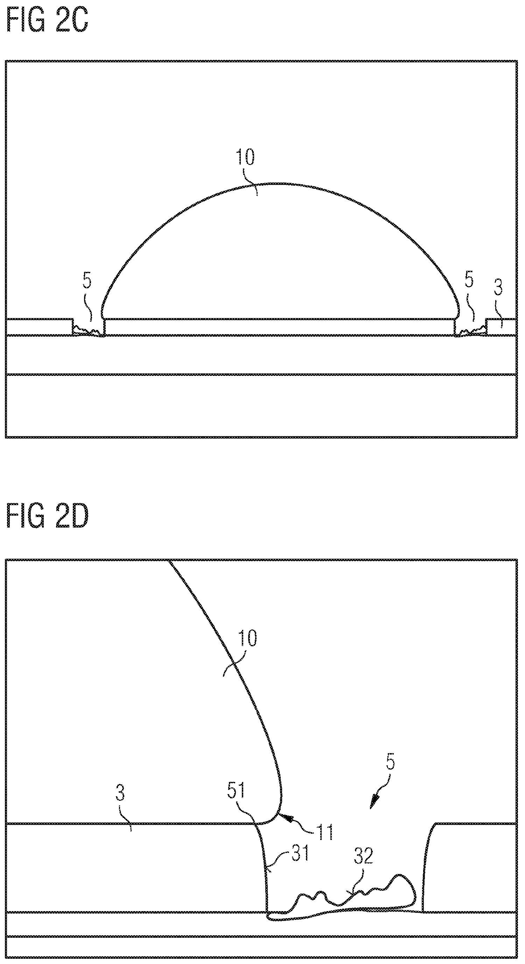

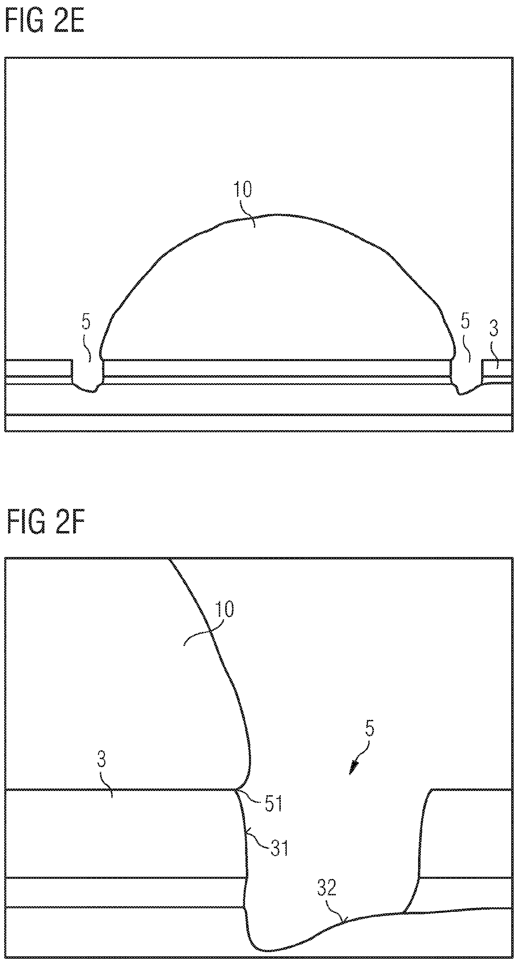

Die mikroskopischen Aufnahmen der Figuren 2A bis 2E zeigen Schnitte durch einen Vergusskörper 10, der zum Beispiel aus einem Silikon gebildet ist, und der auf einer elektrisch isolierenden Schicht 3 angeordnet ist. Wie den Figuren zu entnehmen ist, wirkt die Außenkante 51 der Ausnehmung 5, die dem optoelektronischen Halbleiterchip 8 zugewandt ist, als Stoppkante für das Material des Vergusskörpers 10. Das Merkmal der Figuren 2A bis 2E, dass die Ausnehmung (5) die elektrisch isolierende Folie (3) vollständig durchdringt, ist eine Abwandlung und kein Teil der Erfindung. Der Vergusskörper 10 kann eines der folgenden Materialien enthalten oder aus einem der folgenden Materialien bestehen: Silkon, Polyurethan.

Das Material der elektrisch isolierenden Schicht 3 und das Material des Vergusskörpers 10 sind dabei derart gewählt, dass der Kontaktwinkel α wenigstens 10° beträgt. Es hat sich gezeigt, dass für derart große Kontaktwinkel die Anforderungen an die Qualität der Außenkante 51, das heißt, insbesondere an deren Schärfe, derart gering sind, dass eine wirtschaftliche Herstellung der Ausnehmung, beispielsweise mittels Laserstrahlung, möglich ist.

Als Material für den Vergusskörper 10 kommt vorzugsweise ein UV-härtendes Material zur Verwendung. Der Vorteil der Verwendung von UV-härtendem Material gegenüber einem thermisch härtenden Material besteht darin, dass es zu keiner Verringerung der Viskosität des Materials des Vergusskörpers 10 aufgrund von Temperatureinwirkung beim Aushärten des Materials kommt. UV-härtende Materialien polymerisieren bei Raumtemperatur oder geringfügig erhöhten Temperaturen ganz oder teilweise. Die Gefahr, dass Material des Vergusskörpers 10 in die Ausnehmung 5 tritt und dadurch die Form des Vergusskörpers 10 negativ beeinflusst wird, ist somit verringert.

Eine weitere Möglichkeit zur Verbesserung der Stabilität des dispensierten Vergusskörpers 10 besteht in der gezielten Rheologieänderung vor dem Aushärten des Vergusskörpers 10. Beispielsweise durch das Einbringen von Partikeln oder alternativ von sehr stark verzweigten Molekülen kann die Viskosität des Materials des Vergusskörpers 10 angehoben werden und/oder eine Fließgrenze eingebaut werden. Diese Maßnahmen wirken einem Auseinanderfließen des Vergusskörpers 10 vor dem Aushärten entgegen. Als Thixotropie-Mittel kann zum Beispiel zumindest eines der folgenden Materialien Verwendung finden: Si02, zum Beispiel als pyrogene Kieselsäuren, Al203, Zeolith, Al (OH) 3.

Bei der Abstimmung von elektrisch isolierender Schicht 3 und Material des Vergusskörpers 10 aneinander, können gezielte Anpassungen der Oberflächenbenetzungseigenschaften der verwendeten Materialien vorteilhaft sein. Dies kann durch chemische Additive erfolgen. Geeignet sind Additive, die den Kontaktwinkel (Benetzungswinkel) vergrößern und gleichzeitig das Aushärteverhalten und die Materialeigenschaften des Materials des Vergusskörpers 10 nicht negativ beeinflussen.

## Patentansprüche

1. Optoelektronisches Bauteil mit
- einem Anschlussträger (1) umfassend eine elektrisch isolierende Folie (3) an einer Oberseite (1c) des Anschlussträgers (1),
- einem optoelektronischen Halbleiterchip (8) an der Oberseite (1c) des Anschlussträgers (1),
- einer Ausnehmung (5) in der elektrisch isolierenden Folie (3), die den optoelektronischen Halbleiterchip (8) rahmenartig umschließt, und
- einem Vergusskörper (10), der den optoelektronischen Halbleiterchip (8) umgibt, wobei
- die Ausnehmung (5) die elektrisch isolierende Folie (3) an keiner Stelle durchdringt,
- der Vergusskörper (10) zumindest stellenweise bis zu einer dem optoelektronischen Halbleiterchip (8) zugewandten Außenkante (51) der Ausnehmung (5) reicht, und
- die Ausnehmung (5) zumindest stellenweise frei vom Vergusskörper (10) ist.

2. Optoelektronisches Bauteil gemäß dem vorherigen Anspruch, bei dem das Material des Vergusskörpers (10) höchstens 5 % des Volumens der Ausnehmung (5) ausfüllt.

3. Optoelektronisches Bauteil gemäß einem der vorherigen Ansprüche,
bei dem der Vergusskörper (10) entlang der gesamten Ausnehmung (5) an die dem optoelektronischen Halbleiterchip (8) zugewandten Außenkante (51) der Ausnehmung (5) reicht.

4. Optoelektronisches Bauteil gemäß einem der vorherigen Ansprüche,
bei dem der Anschlussträger (1) eine elektrisch leitende Folie (2) umfasst, die an der der Oberseite (1c) des Anschlussträgers (1) abgewandten Seite der elektrisch isolierenden Folie (3) an der elektrisch isolierenden Folie befestigt ist.

5. Optoelektronisches Bauteil gemäß dem vorherigen Anspruch, bei dem der Anschlussträger aus der elektrisch leitenden Folie (2), der elektrisch isolierenden Folie (3) und gegebenenfalls einem Verbindungsmittel (12) besteht, wobei das Verbindungsmittel (12) zwischen elektrisch leitender Folie (2) und elektrisch isolierender Folie (3) angeordnet sein kann.

6. Optoelektronisches Bauteil gemäß einem der vorherigen Ansprüche,
bei dem die Ausnehmung (5) einen rechteckigen Querschnitt aufweist.

7. Optoelektronisches Bauteil gemäß einem der vorherigen Ansprüche,
bei dem die elektrisch isolierende Folie (3) eines der folgenden Materialen enthält oder aus einem der folgenden Materialien besteht: Polyimid, glasfaserverstärktes Epoxid, Silikon, Polymethacrylimid.

8. Optoelektronisches Bauteil gemäß einem der vorherigen Ansprüche,
bei dem die elektrisch isolierende Folie (3) als Folienverbund aus glasfaserverstärktem Epoxid mit einer Deckschicht aus Polytetrafluorethylen oder Polyetherimid ausgebildet ist.

## Claims

1. Optoelectronic component comprising
- a connection carrier (1) comprising an electrically insulating film (3) at a top side (1c) of the connection carrier (1),
- an optoelectronic semiconductor chip (8) at the top side (1c) of the connection carrier (1),
- a cutout (5) in the electrically insulating film (3), which encloses the optoelectronic semiconductor chip (8) in a frame-like manner, and
- a potting body (10) surrounding the optoelectronic semiconductor chip (8), wherein
- the cutout (5) does not penetrate through the electrically insulating film (3) at any point,
- the potting body (10) extends at least in places as far as an outer edge (51) of the cutout (5) facing the optoelectronic semiconductor chip (8),
- and the cutout (5) is at least regionally free of the potting body (10).

2. Optoelectronic component according to the preceding claim,
wherein the material of the potting body (10) fills at most 5% of the volume of the cutout (5).

3. Optoelectronic component according to any of the preceding claims,
wherein the potting body (10) extends along the entire cutout (5) to the outer edge (51) of the cutout (5) facing the optoelectronic semiconductor chip (8).

4. Optoelectronic component according to any of the preceding claims,
wherein the connection carrier (1) comprises an electrically conducting film (2) fixed to the electrically insulating film at that side of the electrically insulating film (3) which faces away from the top side (1c) of the connection carrier (1).

5. Optoelectronic component according to the preceding claim,
wherein the connection carrier consists of the electrically conductive film (2), the electrically insulating film (3) and, if appropriate, a connecting means (12), wherein the connecting means (12) can be arranged between electrically conductive film (2) and electrically insulating film (3).

6. Optoelectronic component according to any of the preceding claims,
wherein the cutout (5) has a rectangular cross section.

7. Optoelectronic component according to any of the preceding claims,
wherein the electrically insulating film (3) contains one of the following materials or consists of one of the following materials:
polyimide, glass fiber reinforced epoxy, silicone, polymethacrylimide.

8. Optoelectronic component according to any of the preceding claims,
wherein the electrically insulating film (3) is embodied as a film composite composed of glass fiber reinforced epoxy with a cover layer composed of polytetrafluoroethylene or polyetherimide.

## Revendications

1. Composant optoélectronique avec :
- un support de connexion (1) comprenant un film électriquement isolant (3) sur une face supérieure (1c) du support de connexion (1),
- une puce semi-conductrice optoélectronique (8) sur la face supérieure (1c) du support de connexion (1),
- un évidement (5) ménagé dans le film électriquement isolant (3), qui enserre la puce semi-conductrice optoélectronique (8) à la manière d'un cadre, et
- un corps moulé (10) qui entoure la puce semi-conductrice optoélectronique (8), dans lequel
- l'évidement (5) ne traverse en aucun point le film électriquement isolant (3),
- le corps moulé (10) s'étend au moins par endroits jusqu'à un bord extérieur (51) de l'évidement (5) faisant face à la puce semi-conductrice optoélectronique (8), et
- l'évidement (5) est au moins par endroits dégagé du corps moulé (10).

2. Composant optoélectronique selon la revendication précédente, dans lequel le matériau du corps moulé (10) remplit au plus 5 % du volume de l'évidement (5).

3. Composant optoélectronique selon l'une quelconque des revendications précédentes,
dans lequel le corps moulé (10) s'étend le long de la totalité de l'évidement (5) sur le bord extérieur (51) de l'évidement (5) faisant face à la puce semi-conductrice optoélectronique (8).

4. Composant optoélectronique selon l'une quelconque des revendications précédentes,
dans lequel le support de connexion (1) comprend un film électriquement conducteur (2), qui est fixé à la face du film électriquement isolant (3) qui est tournée à l'opposé de la face supérieure (1c) du support de connexion (1) sur le film électriquement isolant.

5. Composant optoélectronique selon la revendication précédente, dans lequel le support de connexion est constitué du film électriquement conducteur (2), du film électriquement isolant (3), et le cas échéant, d'un moyen de liaison (12), dans lequel le moyen de liaison (12) peut être disposé entre le film électriquement conducteur (2) et le film électriquement isolant (3).

6. Composant optoélectronique selon l'une quelconque des revendications précédentes,
dans lequel l'évidement (5) présente une section transversale rectangulaire.

7. Composant optoélectronique selon l'une quelconque des revendications précédentes,
dans lequel le film électriquement isolant (3) contient l'un des matériaux suivants ou est constitué de l'un des matériaux suivants : un polyimide, un époxyde renforcé par des fibres de verre, une silicone, un polyméthacrylimide.

8. Composant optoélectronique selon l'une quelconque des revendications précédentes,
dans lequel le film électriquement isolant (3) est réalisé sous la forme d'un film composite constitué d'un époxyde renforcé par des fibres de verre muni d'une couche de protection constituée de polytétrafluoréthylène ou de polyétherimide.
